# EUROPEAN PATENT APPLICATION

(11) **EP 3 913 518 A1**
(43) Date of publication of application: **24.11.2021**
(21) Application number: 19915396.6
(22) Date of filing: 15.02.2019
(51) Int. Cl.: G06F 30/00

(54) **GRAPHICAL PROGRAMMING METHOD, SYSTEM AND APPARATUS, MEDIUM, PROCESSOR AND TERMINAL**

(71) Applicant: Siemens Ltd., China, Chaoyang District Beijing 100102 (CN)
(72) Inventor: LIU, Luo Sha, Beijing 100020 (CN); PANG, Xiao Yue, Beijing 100032 (CN); WANG, Zi Jia, Beijing 100020 (CN); XIONG, Ge, Beijing 100020 (CN)
(74) Representative: Isarpatent
(86) International application number: PCT/CN2019/075252
(87) International publication number: WO 2020/164125

(57) **Abstract**

A graphical programming method, system and apparatus, a medium, a processor and a terminal. The method comprises : displaying a first component in an interface, wherein the first component is provided with at least one port; displaying a second component in the interface, wherein the second component is provided with at least one port; in response to an operation of a user, enabling the second component to move, in the interface, towards the first component; and in response to the distance between a port of the second component and a port of the first component being less than a predetermined distance, automatically forming a connecting line between the first component and the second component, wherein two ends of the connecting line are respectively connected to a port of the first component and a port of the second component. According to the method, by means of automatically forming a connecting line between ports of components where the distance between the ports of the components is less than a predetermined distance, the time consumption of interaction in graphical programming is reduced, the programming time of a user is saved, and the graphical programming efficiency is improved.

## Description

### Technical Field

The present invention relates to the programming field. In particular, the present invention relates to a graphical programming method, system and apparatus, a medium, a processor and a terminal.

### Background Art

For the graphical programming tool of most robots or automatic systems, it is necessary to establish hardware components of the automatic systems and the connection modes thereof in the preparation stage of programming. Programmers usually need to perform a plurality of interaction steps during the integration and programming processing of automatic systems, and thus, the programming efficiency is lowered.

### Summary of the Invention

The embodiments of the present invention provide a graphical programming method, system and apparatus, a medium, a processor and a terminal to solve the problems of a plurality of interaction steps and a low efficiency in graphical programming of the prior art.

According to one aspect of the embodiments of the present invention, a graphical programming method is provided and the method comprises: displaying a first component on an interface, the first component having at least one port; displaying a second component on the interface, the second component having at least one port; in response to an operation of a user, enabling the second component to move towards the first component on the interface; in response to the distance between one port of the second component and one port of the first component being less than a predetermined distance, automatically forming a connecting line between the first component and the second component, the two ends of the connecting line being connected to one port of the first component and one port of the second component, respectively.

According to another aspect of the embodiments of the present invention, a graphical programming system is provided and the system comprises: a display apparatus, a processor and a memory, wherein the memory stores a program, and when the program is executed by a processor, a first component is displayed on the interface of the display apparatus, the first component having at least one port; a second component is displayed on the interface, the second component having at least one port; in response to an operation of a user, the second component is enabled to move towards the first component on the interface; in response to the distance between one port of the second component and one port of the first component being less than a predetermined distance, a connecting line is automatically formed between the first component and the second component, the two ends of the connecting line being connected to one port of the first component and one port of the second component, respectively.

According to another aspect of the embodiments of the present invention, a graphical programming apparatus is provided, and the apparatus comprises a component library storing at least one component, a first component invocation module invoking a first component from the component library in response to a first input, a second component invocation module invoking a second component from the component library in response to a second input, a display module displaying the invoked first component and second component, a component moving module enabling the second component to move towards the first component on the interface of the display module in response to a third input, and a connecting line generation module automatically forming a connecting line between the first component and the second component in response to the distance between one port of the second component and one port of the first component being less than a predetermined distance, the two ends of the connecting line being connected to one port of the first component and one port of the second component, respectively.

According to the embodiments of the present invention, a connecting line is automatically formed between two components when one component is moved towards another component, thus avoiding a user from operating a connecting line between the two components to connect the ports of the two components, reducing the time spent in interaction steps during programming, and improving the programming efficiency.

In an exemplary implementation mode of the present invention, after a connecting line is automatically formed between the first component and the second component, a list indicating the connection modes between the first component and the second component is automatically displayed on the interface in response to an end of the movement.

Automatically displaying a list indicating the connection modes between the first component and the second component in response to an end of the movement of the second component realizes seamless interactions between the formation of the connecting line between components and the display of the list indicating the connection modes between the first component and the second component, further reduces the time spent in interaction steps during programming and improves the programming efficiency.

In an exemplary implementation mode of the present invention, enabling the second component to move towards the first component on the interface in response to an operation of a user comprises enabling the second component to move towards the first component on the interface in response to mouse-dragging the second component, and automatically displaying a list indicating the connection modes between the first component and the second component on the interface comprises automatically displaying a list indicating the connection modes between the first component and the second component on the interface in response to an up action of the mouse button.

A component is moved in mouse dragging mode and the movement of the component ends through the release of the mouse button. Thus, the operation is simple and the convenience of operation is provided for a user.

In an exemplary implementation mode of the present invention, after a list indicating the connection modes between the first component and the second component is automatically displayed on the interface, a predetermined connection mode is displayed on or near the connecting line in response to the predetermined connection mode selected from the list.

After a predetermined connection mode is selected, the predetermined connection mode is displayed on or near the connecting line. The graphical representation is clear and enables a user to clearly and easily understand the selected connection mode.

In an exemplary implementation mode of the present invention, automatically forming a connecting line between the first component and the second component comprises: automatically forming a connecting line between the first component and the second component to keep the formed connecting line from crossing existing connecting lines.

By automatically forming a connecting line between the first component and the second component, a user can try to avoid crossing existing connecting lines according to the automatically formed connecting line, and thus, the graphical representation of the system is clear.

In an exemplary implementation mode of the present invention, displaying a first component on an interface comprises: displaying a port sign on the first component and adding the port of the first component displayed on the interface in response to triggering the port sign.

A port sign is displayed on a component and a user can add the port of the component by triggering the port sign. Thus, the scalability of the component is improved and the operation convenience of the user is also improved.

According to a further aspect of the embodiments of the present invention, a storage medium is further provided, and the storage medium stores a program, wherein the above-mentioned graphical programming method is implemented when the program is run.

According to a fourth aspect of the embodiments of the present application, a processor is further provided and the processor is configured to run a program, wherein the above-mentioned graphical programming method is implemented when the program is run.

According to a fifth aspect of the embodiments of the present invention, a terminal is further provided, and the terminal comprises: one or more processors and a memory, wherein one or more programs are stored in the memory and are configured to implement the above-mentioned graphical programming method when executed by one or more processors.

In the embodiments of the present invention, during graphical programming, the automatic formation of a connecting line between two components when one component is moved close to another component and the automatic display of a list indicating the connection mode between two components in response to an end of the movement can realize seamless interactions, reduce the time spent in interaction steps and improve the programming efficiency. Thus, the problems of a plurality of interaction steps and a low efficiency in graphical programming of the prior art are solved.

The present invention is applicable to graphical programming applications. After the technique of the present invention is adopted, the experience of the user in the graphical programming tool can be improved.

### Brief Description of the Drawings

The drawings described here are used to provide a better understanding of the present invention and constitute a part of the present invention. The exemplary embodiments and the descriptions of the present invention are used to explain the present invention, but do not constitute an improper limitation of the present invention. In the drawings:
Fig. 1 is a schematic diagram of the components to be connected in the working area of the graphical programming system according to the embodiments of the present invention,
Fig. 2 is a schematic diagram of the components in a connected state in the working area of the graphical programming system according to the embodiments of the present invention,
Fig. 3 shows the settings of connection modes between components in the working area of the graphical programming system according to the embodiments of the present invention,
Fig. 4 shows the system configuration interface of the graphical programming system according to the embodiments of the present invention,
Fig. 5 is a flowchart of the graphical programming method according to the embodiments of the present invention,
Figs. 6A to 6F show the processes of implementing the graphical programming method according to the embodiments of the present invention on the system configuration interface shown in Fig. 4,
Fig. 7 is a block diagram of the graphical programming system according to the embodiments of the present invention, and
Fig. 8 is a block diagram of the graphical programming apparatus according to the embodiments of the present invention.

### Description of reference numerals in the attached drawings

101: Component
103: Component
1011, 1013, 1015: Port
1031, 1033: Port
201, 203, 205, 207, 209, 210: Component
301, 303: Component
3031, 3011: Port
305: List
401: Programming tool navigation
403: Hardware component library
405: Working area
407: Common toolbar
409: Detailed information view and editing area
S501: Display a first component in the working area of the system configuration interface
S503: Configure a connection between the second component and the first component in the working area of the system configuration interface
S505: Add a new component port
S507: Complete configurations
1, 1', 2, 2', 3, 3' : Port
601: List
7: Graphical programming system
701: Memory
703: Processor
705: Display apparatus
8: Graphical programming apparatus
801: Component library
803: Component invocation module
8031: First component invocation module
8033: Second component invocation module
805: Display module
807: Component moving module
809: Connecting line generation module

### Detailed Description of the Invention

To let those skilled in the art better understand the technical solutions of the present invention, the following will clearly and completely describe the technical solutions in the embodiments of the present invention in combination with the drawings in the embodiments of the present invention. Obviously, the embodiments described are only a part, but not all of the embodiments of the present invention. All other embodiments obtained by those skilled in the art on the basis of the embodiments of the present invention without any creative work should fall within the scope of protection of the present invention.

It should be noted that the terms "first" and "second" in the description, claims and the drawings are used to distinguish between similar objects, but not necessarily used to describe a specific order or sequence. It should be understood that the data used in such a way can be interchanged in a proper case so that the described embodiments of the present invention can be implemented in an order other than shown or described here. In addition, the terms "comprise" and "have" and their variants are intended to cover non-exclusive inclusions. For example, the process or method comprising a series of steps or the system, product or device comprising a series of modules or units are unnecessarily limited to those clearly-listed steps or modules or units, but may comprise other steps or modules or units which are not clearly listed or are intrinsic to the process, method, product or device.

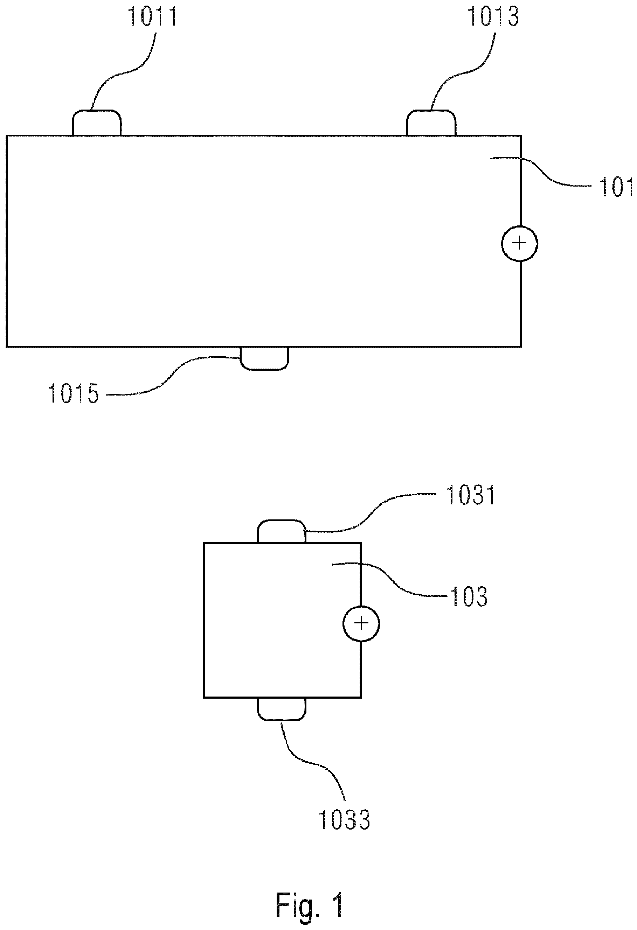

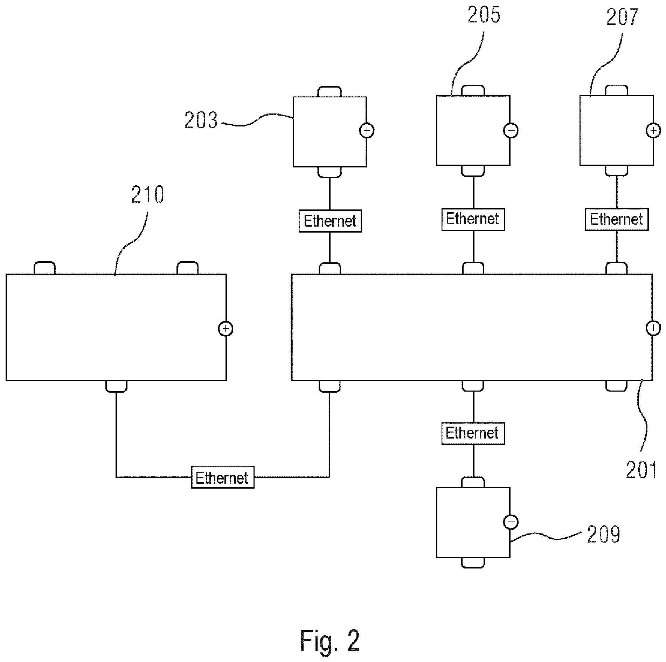

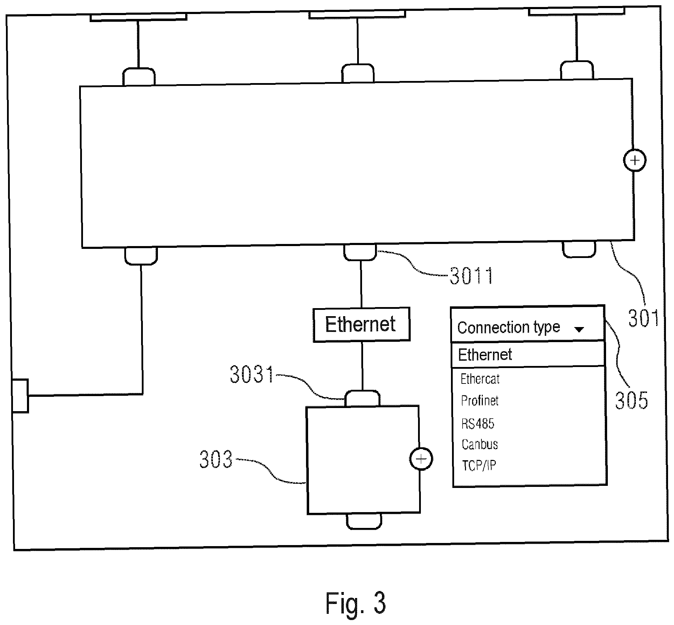

Fig. 1 is a schematic diagram of the components to be connected in the working area of the graphical programming system according to the embodiments of the present invention, Fig. 2 is a schematic diagram of the components in a connected state in the working area of the graphical programming system according to the embodiments of the present invention, and Fig. 3 shows the settings of connection modes between components in the working area of the graphical programming system according to the embodiments of the present invention.

The general conception of the present invention is described below in combination with Figs. 1 to 3.

In Fig. 1, two components 101 and 103 are shown, wherein the component 101 has three ports 1011, 1013 and 1015, and the component 103 has two ports 1031 and 1033.

In the present invention, each component has a flexible number of ports for connections. For example, the components 101 and 103 in Fig. 1 each have a port sign "+", and a user can add a port by clicking "+", as required.

Although Fig. 1 only shows "+", which a user can use to add ports of a component, on the components, the present invention is not limited to this, and "-" can be set on the components so that the user can delete a port of the components, as required.

In Fig. 2, the connection states between the component 201 and the components 203, 205, 207, 209 and 210 are shown. Wherein, alternatively, in the embodiments of the present invention, one port of one component is connected with only one port of another component. As shown in Fig. 2, five ports of the component 201 are connected with one port of the components 203, 205, 207, 209 and 210, respectively. Therefore, each connection between the ports of the component 201 and the components 203, 205, 207, 209 and 210 is clearly presented.

It should be noted that although the components shown in Fig. 2 are different from the components shown in Fig. 1, the present invention is not limited to this and the components shown in Fig. 2 may be the same as the components shown in Fig. 1. Here, Fig. 2 is only used to show the connection state between components, but not used to show the types of components.

In Fig. 3, the components 301 and 303 are shown, and a connection and a connection mode are being set between them.

As shown in Fig. 3, the component 303 is moved close to the component 301, and when the distance between the port 3031 of the component 303 and the port 3011 of the component 301 is less than a predetermined distance, a connecting line is automatically formed between the port 3031 and the port 3011, and the two ends of the connecting line are connected to the port 3031 and the port 3011, respectively. Here, the predetermined distance can be set according to the requirements of a user.

In the present invention, automatically forming a connecting line between ports keeps the formed connecting line from crossing existing connecting lines.

In the present invention, "automatically" should be interpreted as a general meaning in the art and means that the connecting line is autonomously formed by the graphical programming system according to a predetermined condition, instead of being manually drawn out by a user or being dragged out of the existing tools of the graphical programming system.

Here, the way the component 303 is moved close to the component 301 includes but is not limited to: using a mouse to drag the component 303 close to the component 301 or touching a touch screen to drag the component 303 close to the component 301. Touching here includes but is not limited to using a finger of a user to touch a touch screen or using a pen special for a touch screen to touch a touch screen.

As shown in Fig. 3, when a connecting line is automatically formed between the port 3031 and the port 3011, for example, if the mouse dragging the component 303 is released or the dragging action of the user on a touch screen is released, a connection type list indicating the connection mode between the components 301 and 303 is automatically displayed. For example, the list may be a pop-up window 305. In Fig. 3, optional connection types, for example, Ethernet, Ethercat, Profinet, RS485, Canbus and transport control protocol/Internet protocol (TCP/IP) are listed in the pop-up window 305.

A user can select a proper connection type from the pop-up window 305 to set a connection mode between the port 3031 and the port 3011 according to the requirements.

Here, the connection types between components in the pop-up window 305 are only exemplary and the present invention is not limited to the listed connection types.

After a user selects a predetermined connection type "Ethernet" from the list, for example, the pop-up window 305, "Ethernet" indicating the connection mode between the port 3031 and the port 3011 will be displayed on the connecting line between them.

Although "Ethernet" indicating the connection mode between the port 3031 and the port 3011 is displayed on the connecting line in Fig. 3, the present invention is not limited to this and it may be displayed near the connecting line. Or the connection mode is not displayed, or the connection mode is displayed only when the cursor of the mouse approaches the connecting line and/or the connecting line is clicked.

In the embodiments of the present invention, a component may have a flexible number of ports. Alternatively, in some embodiments, one port of one component is connected with only one port of another component, and the connection between component ports is clearly presented, avoiding confusions caused by crossing and twisting of connecting lines between components in an integrated view of system components. In addition, the automatic formation of a connecting line between two components when one component is moved close to another component and the automatic display of a list indicating the connection mode between two components in response to an end of the movement can realize seamless interactions, reduce the time spent in interaction steps and improve the programming efficiency.

For the convenience of subsequent descriptions, the system configuration interface of the graphical programming system according to the embodiments of the present invention will be described below, and the graphical programming method according to the embodiments of the present invention will be implemented on the interface.

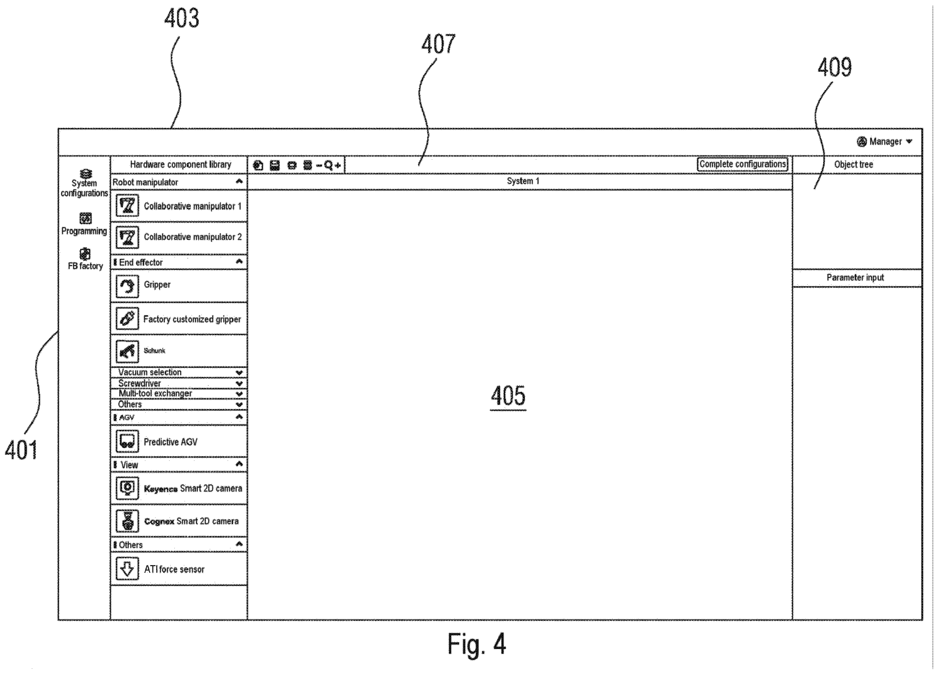

Fig. 4 shows the system configuration interface of the graphical programming system according to the embodiments of the present invention.

As shown in Fig. 4, the system configuration interface of the graphical programming system according to the embodiments of the present invention mainly comprises five parts: programming tool navigation 401, hardware component library 403, working area 405, common toolbar 407 and detailed information view and editing area 409.

In the programming tool navigation 401 on the system configuration interface, "system configurations" is shown in a highlighted way, and the other two programming tools "programming" and "FB factory" of the graphical programming system are shown in a non-highlighted way.

Various components required to be invoked during graphical programming, for example, robot manipulators (including "collaborative manipulator 1" and "collaborative manipulator 2") and end-effectors (including "gripper" and "factory customized gripper") are displayed in the hardware component library 403.

The working area 405 is an area which a user uses for graphical programming.

Tools frequently used during graphical programming, for example, Create button, Save button and Zoom button, are shown on the common toolbar 407. A "Complete configurations" button is also shown on the common toolbar 407. When completing graphical programming, for example, system configurations, in the working area 405, a user can click "Complete Configurations" to complete the configurations and perform the next operation.

A user can enter parameters and view a target tree in the detailed information view and editing area 409, for example.

Since the graphical programming method according to the embodiments of the present invention is mainly completed in the working area of the system configuration interface, detailed descriptions of other buttons irrelevant to the implementation of the graphical programming method of the present invention in the system configuration interface are omitted in the present invention, to avoid redundant descriptions which would make it difficult to understand the present invention.

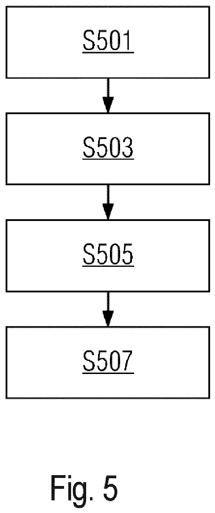

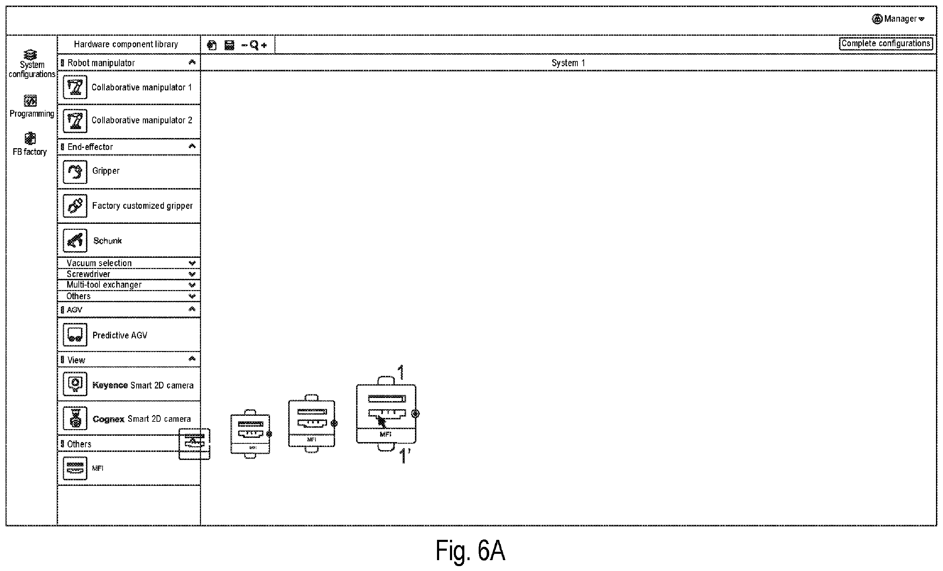

Fig. 5 is a flowchart of the graphical programming method according to the embodiments of the present invention, and Figs. 6A to 6F show the processes of implementing the graphical programming method according to the embodiments of the present invention on the system configuration interface shown in Fig. 4. The graphical programming method according to the embodiments of the present invention will be described below in combination with Fig. 5 and Figs. 6A to 6F.

As shown in Fig. 5, the graphical programming method according to the embodiments of the present invention may comprise:
Step S501: Display a first component in the working area of the system configuration interface.

As shown in Fig. 6A, a required first component, for example, MF1, can be selected from the hardware component library displayed on the left of the system configuration interface, then dragged from the hardware component library to the working area of the system configuration interface and placed in a proper position in the working area of the system configuration interface. Thus, the first component is displayed in the working area of the system configuration interface. For example, through the mouse, the required first component can be selected from the hardware component library and dragged from the hardware component library to the working area of the system configuration interface. Specifically, place the cursor of the mouse on the required first component in the hardware component library, press down the left button or right button of the mouse and drag the mouse until the first component is dragged from the hardware component library to the working area of the system configuration interface. When the display screen is a touch screen, the touch mode may also be used. For example, a finger of a user or a pen special for a touch screen can be used to implement the selection and dragging of the first component. However, the present invention is not limited to those.

For example, the first component MF1 has an upper port 1 and a lower port 1'. A port sign "+" can be seen on the first component MF1. By clicking the port sign "+", a user can add a port.

Step S503: Configure a connection between the second component and the first component in the working area of the system configuration interface.

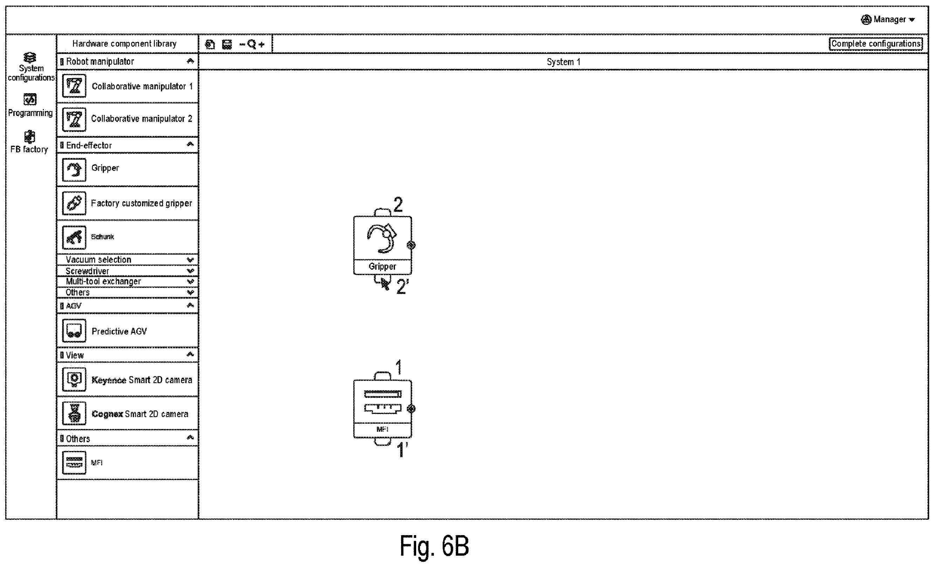

As shown in Fig. 6B, a required second component, for example, "gripper" can be selected from the hardware component library on the system configuration interface, and dragged from the hardware component library to the working area. For example, through the mouse, the required second component can be selected from the hardware component library and dragged from the hardware component library to the working area. Specifically, place the cursor of the mouse on the required second component in the hardware component library, press down the left button (in this case, the main button in the mouse is the "left button". If the main button in the mouse is the "right button", the operation here is "press down the right button of the mouse") and drag the mouse to drag the second component from the hardware component library to the working area of the system configuration interface. When the display screen is a touch screen, the touch mode may also be used. For example, a finger of a user or a pen special for a touch screen can be used to implement the selection and dragging of the second component. However, the present invention is not limited to those.

For example, the second component "gripper" has an upper port 2 and a lower port 2'. A port sign "+" can be seen on the second component "gripper". By clicking the port sign "+", a user can add a port.

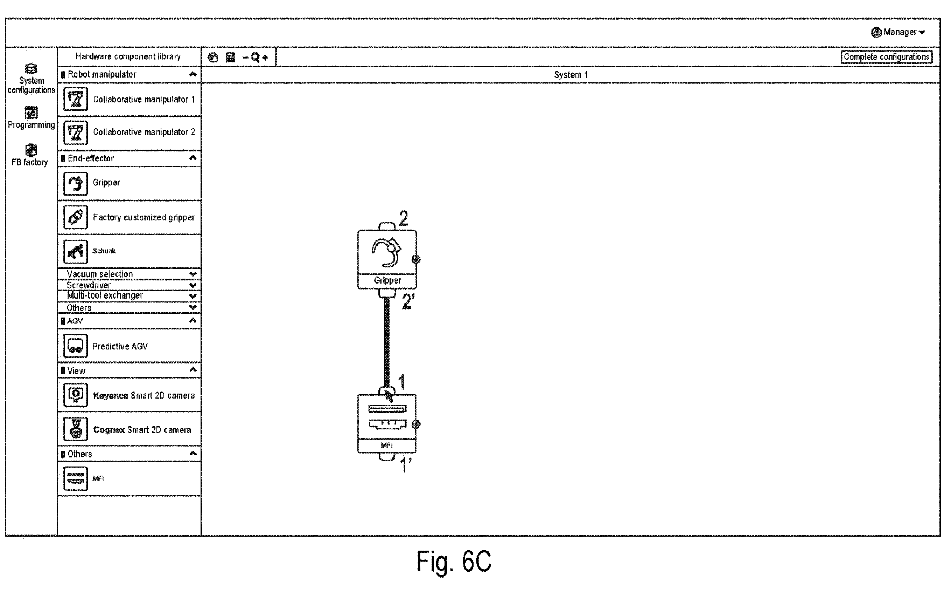

As shown in Fig. 6C, drag the second component "gripper" close to the first component MF1. For example, press down the left button or right button of the mouse and drag the second component "gripper" close to the first component MF1. When the distance between the lower port 2' of the second component "gripper" and the upper port 1 of the first component MF1 is less than a predetermined distance, a connecting line 2'1 is automatically formed between the lower port 2' of the second component "gripper" and the upper port 1 of the first component MF1. The two ends of the connecting line are respectively connected to the lower port 2' of the second component "gripper" and the upper port 1 of the first component MF1 to connect the first component NF1 and the second component "gripper".

Here, the predetermined distance can be set according to the requirements of a user.

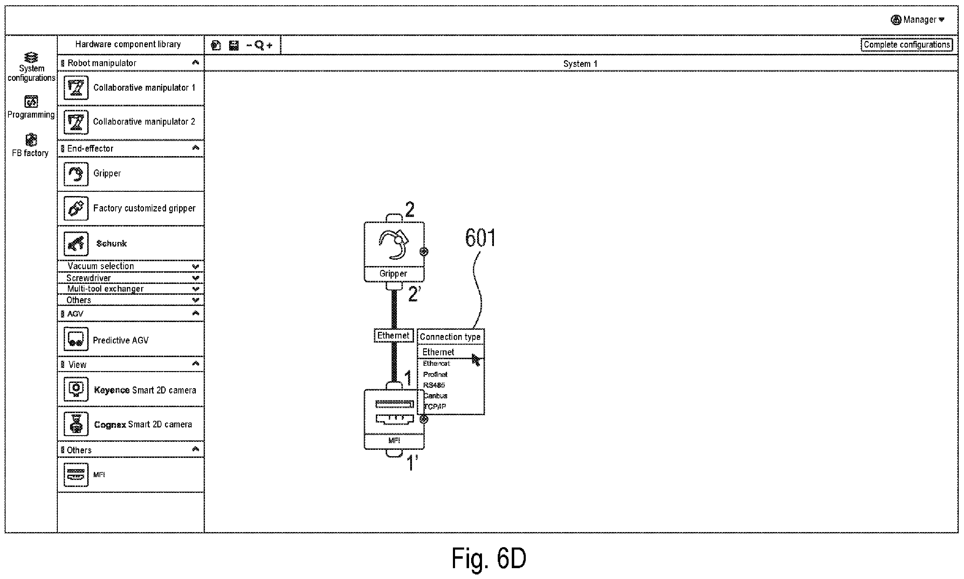

As shown in Fig. 6D, after the connecting line 2'1 between the lower port 2' of the second component "gripper" and the upper port 1 of the first component MF1 is displayed, if dragging the second component "gripper" is released, for example, pressing the left button or right button of the mouse is released to let the left button or right button raise, a connection type list 601 indicating the connection modes between the first component MF1 and the second component "gripper" is automatically displayed near the connecting line 2'1. The connection types in the list 601 include but are not limited to "Ethernet", "Ethercat", "Profinet", "RS485", "Canbus", and "TCP/IP", and a user can set more or fewer connection types as required.

In the present implementation mode, the list 601 may be a pop-up window, but the list in the present invention is not limited to a pop-up window.

A user can select a predetermined connection type from the list 601 as required. For example, the selected connection type in Fig. 6D is "Ethernet" and then the first component MF1 and the second component "gripper" are connected in "Ethernet" mode.

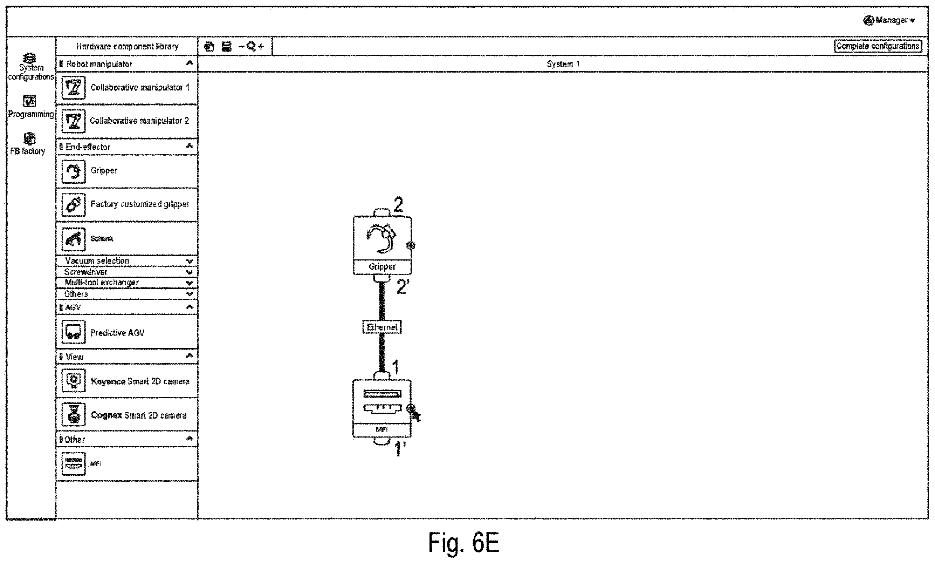

After a predetermined connection type is selected, the connection type "Ethernet" will be displayed on the connecting line 2'1 and the list 501 will automatically disappear, as shown in Fig. 6E.

Although the connection type "Ethernet" is displayed on the connecting line 2'1 in Fig. 6E, the present invention is not limited to this. The connection type "Ethernet" may be displayed near the connecting line 2'1 or in any proper position in the working area. Or the connection mode is not displayed, or the connection mode is displayed only when the cursor of the mouse approaches the connecting line and/or the connecting line is clicked.

Alternatively, the graphical programming method according to the embodiments of the present invention may further comprise:
Step S505: Add a new component port.

For either of the first component and the second component, if new ports need to establish new connections with other components after steps 501 and 503, new ports may be added.

As shown in Fig. 6E, after an "Ethernet" connection is established between the port 1 of the first component MF1 and the port 2' of second component "gripper", if the first component MF1 requires a new port to establish a connection with other components, then trigger the port sign "+" on the first component MF1 to add a new port for the first component MF1. The way of triggering the port sign "+" includes but is not limited to using a mouse to click the port sign "+" and using a finger to click the port sign "+".

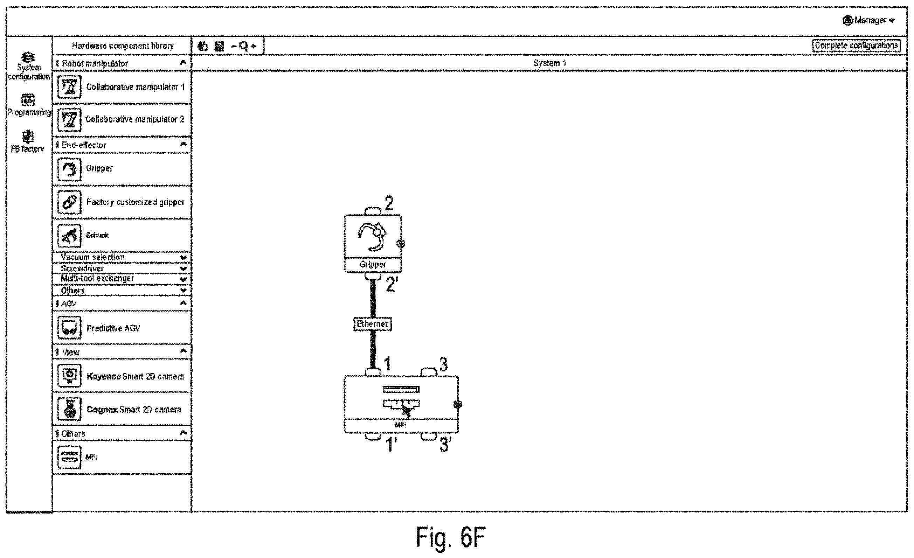

As shown in Fig. 6F, after the port sign "+" on the first component MF1 is triggered, new ports are added for the first component MF1. For example, two ports 3 and 3' are added, as shown in Fig. 6F. Or one port or any predetermined number of ports may be added.

Here, the number of added ports and the positions of the added ports on a component each time the port sign "+" is triggered may be set according to the requirements of a user. Fig. 6F is only an exemplary embodiment and the present invention is not limited to this embodiment.

Although new ports are added only for the first component MF1 in Figs. 6E and 6F, similar operations may be adopted to add new ports for the second component "gripper".

After new ports 3 and 3' are added for the first component MF1, step S503 may be repeated to establish connections between new ports 3 and 3' and the ports of new components.

Although a connection is established between only two components in Figs. 6A to 6F, the present invention is not limited to this and connections may be established between a plurality of components by repeating steps S501 to S505.

Step S507: Complete configurations.

As shown in Fig. 6F, click the "Complete configurations" button on the common toolbar of the system configuration interface to complete the connection configurations between components and perform a next operation.

In the present exemplary embodiment, a component may have a flexible number of ports. Alternatively, one port of one component is connected with only one port of another component, and the connection between component ports is clearly presented, avoiding confusions caused by crossing and twisting of connecting lines between components in an integrated view of system components. In addition, the automatic formation of a connecting line between two components when one component is moved close to another component and the automatic display of a list indicating the connection mode between two components in response to an end of the movement can realize seamless interactions, reduce the time spent in interaction steps and improve the programming efficiency.

In the above-mentioned exemplary embodiment, when the distance between component ports is less than a predetermined distance, a connecting line is automatically formed between component ports. However, the present invention is not limited to this. For example, when one component having a plurality of ports is moved close to a plurality of components having a plurality of ports, the distances between a plurality of ports of one port and a plurality of ports of a plurality of components might be less than a predetermined distance. In this way, connecting lines will automatically be formed between a plurality of ports of one component and a plurality of ports of a plurality of components. In this case, a user can delete unnecessary connecting lines between ports of one component and ports of a plurality of components or modify connecting lines between component ports. In other words, in the present invention, not only a connecting line can automatically be formed between component ports, but also the user can delete connecting lines between ports or modify connecting lines between ports.

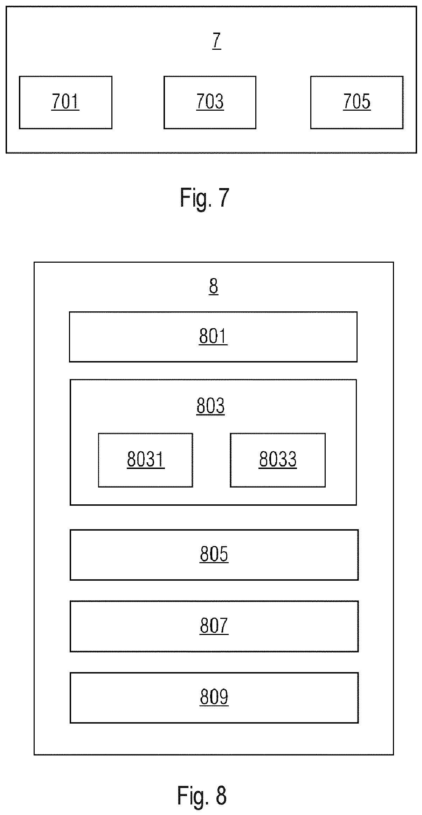

Fig. 7 is a block diagram of the graphical programming system according to the embodiments of the present invention.

As shown in Fig. 7, the graphical programming system 7 according to the embodiments of the present invention comprises a memory 701, a processor 703 and a display apparatus 705. Here, the memory 701 may be a read-only memory (ROM), a random access memory (RAM), optical disk or various storage media, the processor 703 may be a CPU, or one or more chips, and the display apparatus 705 includes but is not limited to a cathode ray tube (CRT) display, liquid crystal display (LCD) or light-emitting diode (LED) display.

A physical or communication connection is established between the memory 701, the processor 703 and the display apparatus 705 in wired and/or wireless mode.

A program which can implement the graphical programming method according to the embodiments of the present invention (described in combination with Figs. 5 and 6A to 6F) is stored in the memory 701. The processor 703 may invoke the program from the memory 701 to implement the graphical programming method according to the embodiments of the present invention. Specifically, when the program invoked from the memory 701 is executed by the processor 703, a first component is displayed on the interface of the display apparatus 705, the first component having at least one port; a second component is displayed on the interface of the display apparatus 705, the second component having at least one port; in response to an operation of a user, the second component is enabled to move towards the first component on the interface of the display apparatus 705; in response to the distance between one port of the second component and one port of the first component being less than a predetermined distance, a connecting line is automatically formed between the first component and the second component, the two ends of the connecting line being connected to one port of the first component and one port of the second component, respectively.

After a connecting line is formed between the first component and the second component, the execution of the program invoked from the memory 701 by the processor 703 further causes a list indicating the connection modes between the first component and the second component to be automatically displayed on the interface in response to an end of the movement.

In the present embodiment, when the program invoked from the memory 701 is executed by the processor 703, the second component is enabled to move towards the first component on the interface in response to mouse-dragging the second component, and a list indicating the connection modes between the first component and the second component is automatically displayed on the interface in response to an up action of the mouse button.

After a list indicating the connection modes between the first component and the second component is automatically displayed on the interface of the display apparatus 705, the execution of the program invoked from the memory 701 by the processor 703 further causes a predetermined connection mode to be displayed on or near the connecting line in response to the predetermined connection mode selected from the list.

In the present embodiment, displaying a first component on the interface of the display apparatus 705 comprises displaying a port sign on the first component. For example, after a predetermined connection mode is displayed on or near a connecting line, the execution of the program invoked from the memory 701 by the processor 703 further causes a port of the first component displayed on the interface to be added in response to triggering the port sign.

Although a port can be added for the first component and/or second component by triggering the port sign after a predetermined connection mode is displayed on or near a connecting line between the first component and the second component, the present invention is not limited to this. As required, a port can be added for a component at a proper time. For example, the port sign of the first component and/or second component may be triggered to add ports of the first component and/or second components after the first component and/or second component is displayed on the interface.

In the present embodiment, automatically forming a connecting line between the first component and the second component can keep the formed connecting line from crossing existing connecting lines.

Fig. 8 is a block diagram of the graphical programming apparatus according to the embodiments of the present invention.

As shown in fig. 8, the graphical programming apparatus 8 according to the embodiments of the present invention comprises a component library 801, a component invocation module 803, a display module 805, a component moving module 807 and a connecting line generation module 809, wherein the component invocation module 803 further comprises a first component invocation module 8031 and a second component invocation module 8033.

The component library 801, the component invocation module 803, the display module 805, the component moving module 807 and the connecting line generation module 809 are physically connected or communication-connected with each other in wired and/or wireless mode.

At least one component is stored in the component library 801. When the graphical programming method according to the embodiments of the present invention is executed, the component invocation module 803 invokes components from the component library 801. Specifically, the first component invocation module 8031 of the component invocation module 803 invokes a first component from the component library 801 in response to a first input, and the second component invocation module 8033 of the component invocation module 803 invokes a second component from the component library 801 in response to a second input. Here, the first input and the second input may be a user's drag of a required component in the component library through a mouse or a finger. However, the present invention is not limited to this. For example, the first input and the second input may also be a key operation on a keyboard or a parameter input through the keyboard.

The display module 805 may display a first component invoked by the first component invocation module 8031 from the component library 801 and a second component invoked by the second invocation module 8033 from the component library 801. In the present implementation mode, the display module 805 displaying a first component and a second component comprises displaying a port sign on the first component and the second component. Through the port sign, a use can add ports on the first component and the second component.

The component moving module 807 may enable the second component to move towards the first component on the interface of the display module 805 in response to a third input. Here, the third input may be a user's drag of the second component through a mouse or a finger. However, the present invention is not limited to this. For example, the third input may also be a key operation on a keyboard or a parameter input through the keyboard. It should be noted that the third input may also be a continuation of the second input. For example, after a user clicks a component in the component library 801, the user drags the component to the interface of the display module 805 and continues to drag the second component towards the first component without releasing the mouse button. In this case, the third input is a continuation of the second input.

The connecting line generation module 809 may automatically form a connecting line between the first component and the second component in response to the distance between one port of the second component and one port of the first component being less than a predetermined distance, wherein the two ends of the connecting line are connected to one port of the first component and one port of the second component, respectively.

Alternatively, the graphical programming apparatus 8 according to the embodiments of the present invention may further comprise a list display module (not shown in Fig. 8), and the list display module is physically connected or communication-connected with the component library 801, the component invocation module 803, the display module 805, the component moving module 807 and the connecting line generation module 809 in wired and/or wireless mode.

After the connecting line generation module 809 automatically forms a connecting line between the first component and the second component, the list display module may automatically display a list indicating the connection modes between the first component and the second component on the interface of the display module 805 in response to an end of the movement of the second component towards the first component.

In the present embodiment, the connecting line generation module 809 may enable the second component to move towards the first component on the interface of the display module 805, for example, in response to mouse-dragging the second component. The list display module may automatically display a list indicating connection modes between the first component and the second component on the interface of the display module 805, for example, in response to an up action of the mouse button.

Alternatively, the graphical programming apparatus 8 according to the embodiments of the present invention may further comprise a connection mode selection module (not shown in Fig. 8), and the connection mode selection module is physically connected or communication-connected with the component library 801, the component invocation module 803, the display module 805, the component moving module 807 and the connecting line generation module 809 in wired and/or wireless mode.

After a list indicating the connection modes between the first component and the second component is automatically displayed on the interface of the display module 805, the connection mode selection module may select a predetermined connection mode from the list in response to a fourth input. Here, the fourth input may be a user's click of a predetermined connection mode in the list through a mouse or a finger. However, the present invention is not limited to this. For example, the fourth input may also be a key operation on a keyboard or a parameter input through the keyboard.

The display module 805 displays a predetermined connection mode on or near the connecting line between the first component and the second component in response to the predetermined connection mode selected by the connection mode selection module from the list.

Alternatively, the graphical programming apparatus 8 according to the embodiments of the present invention may further comprise a port addition module (not shown in Fig. 8), and the port addition module is physically connected or communication-connected with the component library 801, the component invocation module 803, the display module 805, the component moving module 807 and the connecting line generation module 809 in wired and/or wireless mode.

For example, after a predetermined connection mode is displayed on or near the connecting line between the first component and the second component, the port addition module may add ports of the first component and/or the second component on the interface of the display module 805 in response to triggering the port sign on the first component and/or the second component. Here, the way of triggering the port sign includes but is not limited to clicking the port sign through the mouse or a finger, a key operation on the keyboard or a digital input through a keyboard.

Although a port can be added for the first component and/or second component by triggering the port sign after a predetermined connection mode is displayed on or near a connecting line between the first component and the second component, the present invention is not limited to this. As required, a port can be added for a component at a proper time. For example, the port sign of the first component and/or second component may be triggered to add ports of the first component and/or second components after the first component and/or second component is displayed on the interface.

In the present embodiment, automatically forming a connecting line between the first component and the second component can keep the formed connecting line from crossing existing connecting lines.

The above-mentioned modules of the graphical programming apparatus according to the embodiments of the present invention may be program modules stored in a storage medium. When the processor invokes these program modules, the graphical programming method described in Figs. 5 and 6A to 6F may be executed.

According to the embodiments of the present invention, a storage medium is further provided, and the storage medium stores a program, wherein the above-mentioned graphical programming method is implemented when the program is run.

According to the embodiments of the present application, a processor is further provided, the processor is configured to run a program, and the above-mentioned graphical programming method is implemented when the program is run. The processor here includes but is not limited to one or more chips.

According to the embodiments of the present invention, a terminal is further provided, and the terminal comprises: one or more processors and a memory, wherein one or more programs are stored in the memory and are configured to implement the above-mentioned graphical programming method when executed by one or more processors.

Specifically, when one or more programs stored in the memory are executed by the processor, the following operations may be performed:
displaying a first component on an interface, the first component having at least one port; displaying a second component on the interface, the second component having at least one port; in response to an operation of a user, enabling the second component to move towards the first component on the interface; in response to the distance between one port of the second component and one port of the first component being less than a predetermined distance, automatically forming a connecting line between the first component and the second component, the two ends of the connecting line being connected to one port of the first component and one port of the second component, respectively.

The interface here may be the interface of the terminal or the interface of a display apparatus connected with the terminal in wired or wireless mode, and the present invention is not limited to those.

After a connecting line is automatically formed between the first component and the second component, the execution of one or more programs stored in the memory by the processor further causes a list indicating the connection modes between the first component and the second component to be automatically displayed on the interface in response to an end of the movement.

In the present embodiment, when one or more programs are executed by the processor, the second component is enabled to move towards the first component on the interface in response to mouse-dragging the second component, and a list indicating the connection modes between the first component and the second component is automatically displayed on the interface in response to an up action of the mouse button.

After a list indicating the connection modes between the first component and the second component is automatically displayed on the interface, the execution of one or more programs in the memory by the processor may further cause a predetermined connection mode to be displayed on or near the connecting line in response to the predetermined connection mode selected from the list.

In the present embodiment, displaying a first component on the interface comprises displaying a port sign on the first component. After a predetermined connection mode is displayed on or near a connecting line, the execution of one or more programs stored in the memory by the processor further causes a port of the first component displayed on the interface to be added in response to triggering the port sign.

Although a port can be added for the first component and/or second component by triggering the port sign after a predetermined connection mode is displayed on or near a connecting line between the first component and the second component, the present invention is not limited to this. As required, a port can be added for a component at a proper time. For example, the port sign of the first component and/or second component may be triggered to add ports of the first component and/or second components after the first component and/or second component is displayed on the interface.

In the present embodiment, automatically forming a connecting line between the first component and the second component can keep the formed connecting line from crossing existing connecting lines.

Among the above-described embodiments of the present invention, each embodiment has its own focal points . For the parts not described in an embodiment, please refer to the related description in other embodiments.

It should be understood that the technical content disclosed in the embodiments of the present invention can be realized in other ways. The above-described embodiments of the apparatus are given only for the illustrative purpose. The division of units or modules is only a logical function division, and other division methods may be used in the actual realization. For example, a plurality of units or modules or components may be combined or integrated into another system, or some features may be ignored or may not be executed. In addition, the shown or discussed couplings, or direct couplings or communication connections between them may be indirect couplings or communication connections, electrical or otherwise, through some interfaces, modules or units.

The unit or module described as a separate part may be or may not be physically separated, and the part shown as a unit or module may be or may not be a physical unit or module, that is to say, it may be located at one place or may be distributed to a plurality of network units or modules. Part or all of the units or modules may be selected to realize the solutions of the embodiments according to the actual requirement.

In addition, the functional units or modules in each embodiment of the present invention may be integrated into a processing unit or module, or each unit or module may physically exist separately, or two or more units or modules may be integrated into a unit or module. The above-mentioned integrated unit or module may be realized in the form of hardware or in the form of a software functional unit or module.

The integrated unit may be stored in a computer-readable storage medium if it is realized in the form of a software functional unit and is marketed or used as an independent product. Based on such an understanding, the technical solution of the present invention or the part which makes contributions to the prior art, or all or part of the technical solution may essentially be represented in the form of a software product, and the computer software product is stored in a storage medium and comprises a plurality of instructions to enable a computer (PC, server or network equipment) to execute all or part of the steps of the method described in the embodiments of the present invention. The above-mentioned storage medium includes USB disk, read-only memory (ROM), random access memory (RAM), mobile hard disk, magnetic disk or optical disk and other various media which can store program codes.

Only preferred embodiments of the present invention are described above. It should be pointed out that those skilled in the art can make improvements and modifications without departing from the principle of the present invention and these improvements and modifications should also fall within the scope of protection of the present invention.

## Claims

1. A graphical programming method, **characterized in that** the method comprises:
displaying a first component on an interface, the first component having at least one port,
displaying a second component on the interface, the second component having at least one port,
enabling the second component to move towards the first component on the interface in response to an operation of a user, and
automatically forming a connecting line between the first component and the second component in response to the distance between one port of the second component and one port of the first component being less than a predetermined distance, the two ends of the connecting line being connected to one port of the first component and one port of the second component, respectively.

2. The method as claimed in claim 1, wherein after the connecting line is automatically formed between the first component and the second component, the method further comprises:
automatically displaying a list indicating the connection modes between the first component and the second component on the interface in response to an end of the movement.

3. The method as claimed in claim 2, wherein
enabling the second component to move towards the first component on the interface in response to an operation of a user comprises:
enabling the second component to move towards the first component on the interface in response to mouse-dragging the second component;
automatically displaying a list indicating the connection modes between the first component and the second component on the interface in response to an end of the movement comprises:
automatically displaying a list indicating the connection modes between the first component and the second component on the interface in response to an up action of the mouse button.

4. The method as claimed in claim 2 or 3, wherein after automatically displaying a list indicating connection modes between the first component and the second component on the interface, the method further comprises: displaying a predetermined connection mode on or near the connecting line in response to the predetermined connection mode selected from the list.

5. The method as claimed in any of claims 1 to 4, wherein automatically forming a connecting line between the first component and the second component comprises:
automatically forming a connecting line between the first component and the second component to keep the formed connecting line from crossing existing connecting lines.

6. The method as claimed in any of claims 1 to 4, wherein displaying the first component on the interface comprises:
displaying a port sign on the first component, and the method further comprises:
adding a port of the first component displayed on the interface in response to triggering the port sign.

7. A graphical programming system, **characterized in that** the graphical programming system comprises:
a display apparatus, a processor and a memory,
wherein the memory stores a program and the execution of the program by the processor causes,
a first component to be displayed on the interface of the display apparatus, the first component having at least one port,
a second component to be displayed on the interface, the second component having at least one port,
the second component to move towards the first component on the interface in response to an operation of a user, and
a connecting line to be automatically formed between the first component and the second component in response to the distance between one port of the second component and one port of the first component being less than a predetermined distance, the two ends of the connecting line being connected to one port of the first component and one port of the second component, respectively.

8. The graphical programming system as claimed in claim 7, wherein after the connecting line is automatically formed between the first component and the second component, the execution of the program by the processor further causes
a list indicating the connection modes between the first component and the second component to be automatically displayed on the interface in response to an end of the movement.

9. The graphical programming system as claimed in claim 8, wherein
the execution of the program by the processor causing the second component to move towards the first component on the interface in response to an operation of a user comprises:
enabling the second component to move towards the first component on the interface in response to mouse-dragging the second component,
automatically displaying a list indicating the connection modes between the first component and the second component on the interface in response to an end of the movement at the execution of the program by the processor comprises:
automatically displaying a list indicating the connection modes between the first component and the second component on the interface in response to an up action of the mouse button.

10. The graphical programming system as claimed in claim 8 or 9, wherein after a list indicating the connection modes between the first component and the second component is automatically displayed on the interface, the execution of the program by the processor further causes
a predetermined connection mode to be displayed on or near the connecting line in response to the predetermined connection mode selected from the list.

11. The graphical programming system as claimed in any of claims 7 to 10, wherein the execution of the program by the processor causing a connecting line to be automatically formed between the first component and the second component comprises:
automatically forming a connecting line between the first component and the second component to keep the formed connecting line from crossing existing connecting lines.

12. The graphical programming system as claimed in any of claims 7 to 10, wherein the execution of the program by the processor causing the first component to be displayed on the interface comprises: displaying a port sign on the first component,
the execution of the program by the processor further causes
a port of the first component displayed on the interface to be added in response to triggering the port sign.

13. A graphical programming apparatus, **characterized in that** the apparatus comprises:
a component library, storing at least one component,
a first component invocation module, invoking a first component from the component library in response to a first input,
a second component invocation module, invoking a second component from the component library in response to a second input,
a display module, displaying the invoked first component and second component,
a component moving module, enabling the second component to move towards the first component on the interface of the display module in response to a third input, and
a connecting line generation module, automatically forming a connecting line between the first component and the second component in response to the distance between one port of the second component and one port of the first component being less than a predetermined distance, the two ends of the connecting line being connected to the one port of the first component and the one port of the second component, respectively.

14. A storage medium, **characterized in that** the storage medium stores a program, wherein the program implements the method as claimed in any of claims 1 to 6 when run.

15. A processor, **characterized in that** the processor is configured to run a program, wherein the program implements the method as claimed in any of claims 1 to 6 when run.

16. A terminal, **characterized in that** the terminal comprises one or more processors and a memory, wherein one or more programs are stored in the memory and are configured to implement the method as claimed in any of claims 1 to 6 when executed by the one or more processors.
